# FASCICULE DE BREVET EUROPEEN

(11) **EP 3 427 383 B1**
(45) Date de publication et mention de la délivrance du brevet: **12.01.2022**
(21) Numéro de dépôt: 17714853.3
(22) Date de dépôt: 10.03.2017
(51) Int. Cl.: G06F 11/14, G06F 9/38, H03K 19/003

(54) **COMMUNICATIONS ASYNCHRONES RÉSISTANT AUX RAYONNEMENTS**
STRAHLUNGSBESTÄNDIGE ASYNCHRONE KOMMUNIKATION
RADIATION-RESISTANT ASYNCHRONOUS COMMUNICATIONS

(30) Priorité: 11.03.2016 FR 1652074
(43) Date de publication de la demande: 16.01.2019
(73) Titulaire: Commissariat à l'Energie Atomique et aux Energies Alternatives, 75015 Paris (FR); Centre National de la Recherche Scientifique, 75794 Paris Cedex 16 (FR)
(72) Inventeur: LOPES, Jeremy, 38100 Grenoble (FR); DI PENDINA, Gregory, 38130 Echirolles (FR)
(74) Mandataire: Cabinet Beaumont
(86) Numéro de dépôt international: PCT/FR2017/050544
(87) Numéro de publication internationale: WO 2017/153696

(56) Documents cités:
- EP-A1- 2 993 786
- US-A1- 2007 262 786
- US-A1- 2010 185 909
- US-A1- 2013 113 519
- US-A1- 2015 268 962

## Description

La présente demande de brevet revendique la priorité de la demande de brevet français FR16/52074 qui sera considérée comme faisant partie intégrante de la présente description.

### Domaine de l'invention

La présente description concerne le domaine des communications asynchrones, et en particulier des circuits asynchrones ayant une résistance renforcée aux rayonnements.

### Exposé de l'art antérieur

Contrairement aux conceptions à circuits synchrones qui reposent sur un signal d'horloge, les circuits asynchrones présentent l'avantage d'être plus ou moins insensibles aux variations de retards résultant par exemple de variations dans le processus de fabrication. En outre, en évitant l'utilisation d'une horloge, les circuits asynchrones ont une consommation d'énergie relativement faible. Les circuits asynchrones sont en général conçus pour fonctionner sur la base d'événements déterminés en utilisant un protocole de poignée de main spécifique.

L'élément de base d'un circuit d'une conception asynchrone est un circuit connu sous le nom de porte C ou cellule de Muller. Ce circuit comprend une bascule volatile pour mémoriser un état. Ainsi, si le circuit asynchrone voit son alimentation coupée, les données mémorisées par les diverses portes C seront perdues.

Un pipeline asynchrone est en général constitué d'étages, chaque étage comprenant un demi-tampon constitué de plusieurs portes C.

Pour des applications avioniques et/ou spatiales, il serait souhaitable d'obtenir un circuit asynchrone qui soit renforcé contre les effets des rayonnements. En effet, la présence de particules ionisantes aux altitudes élevées ou dans l'espace peut induire dans les circuits intégrés des courants qui peuvent être suffisants pour provoquer un basculement de l'état binaire maintenu par une ou plusieurs portes. Cela peut provoquer un dysfonctionnement du circuit, connu dans la technique sous le nom de dérangement par événement singulier (SEU).

On a proposé d'assurer une redondance modulaire double (DMR) ou une redondance modulaire triple (TMR) dans une conception de circuit asynchrone afin d'assurer une protection contre les rayonnements. De telles techniques reposent sur la duplication du circuit dans le cas de la DMR, ou sur le triplement du circuit dans le cas de la TMR, et sur la détection d'une discordance entre les sorties des circuits comme indication de l'occurrence d'un SEU.

Un problème avec la technique DMR est qu'elle ne permet pas de corriger l'erreur, et ainsi quand une erreur est détectée, le circuit est simplement réinitialisé. Cela ajoute un retard, puisque l'opération de traitement doit être redémarrée. En outre, si des SEU surviennent à une cadence relativement élevée, il peut même être impossible qu'une opération de traitement soit terminée avant qu'une réinitialisation soit requise.

La technique TMR permet de corriger l'erreur, par exemple en sélectionnant la valeur de sortie générée par deux des trois circuits. Toutefois, un inconvénient avec la technique TMR est que la surface et la consommation d'énergie du circuit sont augmentées d'un facteur trois.

On a donc besoin dans la technique d'un circuit ayant une surface et une consommation d'énergie relativement faibles, et qui permette une récupération à la suite d'un SEU sans nécessiter de réinitialisation.

La demande de brevet américaine publiée sous le numéro US2015/268962 décrit un pipeline asynchrone.

### Résumé

Un objet de modes de réalisation de la présente description est de répondre à un ou plusieurs besoins de l'art antérieur.

Selon un aspect de l'invention, on prévoit un circuit asynchrone comprenant : un premier circuit adapté à recevoir, à partir d'un premier autre circuit, un premier signal d'entrée de données sur une première ligne d'entrée de données et à générer un premier signal d'accusé de réception et un premier signal de sortie de données ; un deuxième circuit adapté à recevoir, à partir d'un deuxième autre circuit, un deuxième signal d'entrée de données sur une deuxième ligne d'entrée de données et à générer un deuxième signal d'accusé de réception et un deuxième signal de sortie de données, le deuxième circuit étant fonctionnellement équivalent au premier circuit ; un comparateur, adapté à détecter une discordance entre les premier et deuxième signaux de sortie de données ; un autre comparateur adapté à détécter une discordance entre les premier et deuxième signaux d'entrée de données; au moins un circuit de mise en pause d'accusé de réception adapté à empêcher la propagation des premier et deuxième signaux d'accusé de réception vers les premier et deuxième autres circuits si une discordance est détectée par le comparateur ou par l'autre comparateur; et un circuit de mémoire non volatile couplé à la première ligne d'entrée de données et adapté à mémoriser une première valeur du premier signal d'entrée de données lorsque l'autre comparateur n'indique pas une discordance entre les premier et deuxième signaux d'entrée de données.

Selon un mode de réalisation, le circuit de mémoire non volatile est en outre adapté à fournir la première valeur mémorisée en réponse à une discordance détectée entre les premier et deuxième signaux de sortie de données.

Selon un mode de réalisation, le circuit de mémoire non volatile est adapté à fournir la première valeur mémorisée sur des lignes de données transmettant les premier et deuxième signaux d'entrée de données.

Selon un mode de réalisation, le circuit de mémoire non volatile comprend au moins un élément de mémorisation non volatile programmable pour maintenir, de manière non volatile, l'un d'une pluralité d'états résistifs.

Selon un mode de réalisation, ledit au moins un circuit de mise en pause d'accusé de réception est adapté à propager les premier et deuxième signaux d'accusé de réception soit une fois que le comparateur indique une concordance entre les premier et deuxième signaux d'entrée de données, soit une fois que le comparateur indique une concordance entre les premier et deuxième signaux de sortie de données.

Selon un mode de réalisation, chacun desdits au moins un circuit de mise en pause d'accusé de réception est une porte logique adaptée à recevoir le premier ou le deuxième signal d'accusé de réception et un signal de sortie du comparateur.

Selon un mode de réalisation, les premier et deuxième circuits sont des circuits de réception synchrones, et : le premier autre circuit est un premier circuit de transmission synchrone adapté à générer le premier signal d'entrée de données et à le transmettre au premier circuit ; et le deuxième autre circuit est un deuxième circuit de transmission synchrone adapté à générer le deuxième signal d'entrée de données et à le transmettre au deuxième circuit.

Selon un autre aspect, on prévoit un pipeline asynchrone comprenant le circuit asynchrone susmentionné, le pipeline asynchrone comprenant : un premier sous-pipeline comprenant une première pluralité d'étages dont l'un comprend le premier circuit ; et un deuxième sous-pipeline comprenant une deuxième pluralité d'étages dont l'un comprend le deuxième circuit.

Selon un autre aspect de l'invention, on prévoit un procédé de détection et de correction de dérangements par événement singulier dans un circuit asynchrone comprenant : recevoir par un premier circuit, à partir d'un premier autre circuit, un premier signal d'entrée de données sur une première ligne d'entrée de données et générer par le premier circuit un premier signal d'accusé de réception et un premier signal de sortie de données ; recevoir par un deuxième circuit, à partir d'un deuxième autre circuit, un deuxième signal d'entrée de données sur une deuxième ligne d'entrée de données et générer par le deuxième circuit un deuxième signal d'accusé de réception et un deuxième signal de sortie de données, le deuxième circuit étant fonctionnellement équivalent au premier circuit ; comparer, par un comparateur, les premier et deuxième signaux de sortie de données, pour détecter une discordance ; comparer, par un autre comparateur, les premier et deuxième signaux d'entrée de données pour détecter une discordance; empêcher, par au moins un circuit de mise en pause d'accusé de réception, la propagation des premier et deuxième signaux d'accusé de réception vers les premier et deuxième autres circuits si une discordance est détectée entre les premier et deuxième signaux d'entrée de données ou entre les premier et deuxième signaux de sortie de données; et mémoriser, par un circuit de mémoire non volatile couplé à la première ligne d'entrée de données, une première valeur du premier signal d'entrée de données lorsque l'autre comparateur n'indique pas de discordance entre les premiers et deuxième signaux d'entrée de données.

### Brève description des dessins

Les objets et avantages susmentionnés, et d'autres, apparaîtront clairement avec la description détaillée suivante de modes de réalisation, donnés à titre d'illustration et non de limitation, en faisant référence aux figures jointes parmi lesquelles :
la figure 1 illustre schématiquement un pipeline asynchrone selon un exemple de réalisation ;
la figure 2 illustre schématiquement un demi-tampon de N bits selon un exemple de réalisation ;
la figure 3 est un chronogramme illustrant un exemple de signaux mettant en œuvre un protocole de poignée de main dans le circuit de la figure 2 selon un exemple de réalisation ;
la figure 4 illustre schématiquement un pipeline asynchrone résistant aux rayonnements selon un exemple de réalisation de la présente description ;
la figure 5 est un chronogramme illustrant des signaux dans le circuit de la figure 4 selon un exemple de réalisation de la présente description ;
la figure 6 illustre schématiquement un pipeline asynchrone ayant une mémorisation non volatile selon un mode de réalisation de la présente invention;
la figure 7 est un chronogramme illustrant des signaux dans le circuit de la figure 6 selon un mode de réalisation de la présente invention;
la figure 8A illustre un circuit de mémorisation non volatile de la figure 6 selon un mode de réalisation de la présente invention;
la figure 8B illustre le circuit de mémorisation non volatile de la figure 8A plus en détail selon un mode de réalisation de la présente invention ; et
la figure 9 illustre schématiquement une interface de communication asynchrone entre des circuits selon un mode de la présente invention.

### Description détaillée

Dans la description détaillée suivante, le terme "connecté" est utilisé pour désigner une connexion directe entre des éléments d'un circuit, alors que le terme "couplé" est utilisé pour désigner une connexion qui peut être directe, ou peut se faire par l'intermédiaire d'un ou plusieurs éléments intermédiaires comme des résistances, des condensateurs ou des transistors.

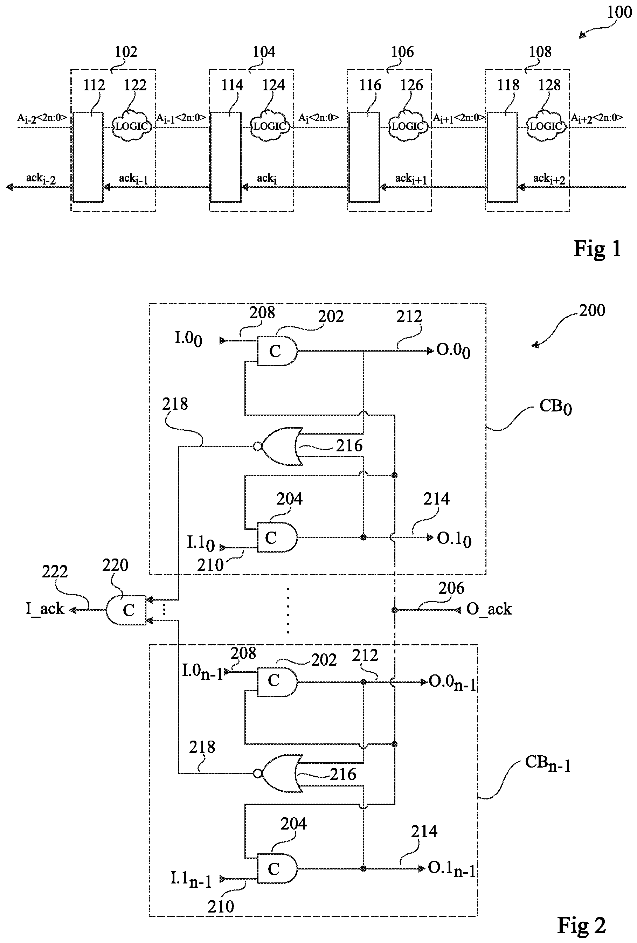

La figure 1 illustre schématiquement un pipeline asynchrone 100 selon un exemple de réalisation non revendiqué. Le pipeline 100 comprend par exemple au moins deux étages de pipeline couplés en série. Dans l'exemple de la figure 1, il y a quatre étages de pipeline 102, 104, 106 et 108. Chaque étage de pipeline 102, 104, 106 et 108 comprend un demi-tampon 112, 114, 116 et 118 respectivement, qui est par exemple un demi-tampon de n bits. Les demi-tampons 112 à 118 reçoivent respectivement des signaux de données de n bits sur des lignes Aᵢ₋₂<2n:0> à Aᵢ₊₁<2n:0>.

Chacun des étages 102 à 108 comprend aussi par exemple respectivement un circuit logique (LOGIC) 122, 124, 126 et 128, qui réalise par exemple une fonction logique sur les données avant de fournir le résultat à l'étage suivant.

Bien que cela ne soit pas illustré en figure 1, le pipeline est par exemple terminé par un tampon capable de mémoriser les données provenant du pipeline et de générer un signal d'accusé de réception vers le dernier demi-tampon du pipeline.

La figure 2 illustre schématiquement un exemple d'un demi-tampon à n bits 200, ce circuit étant par exemple utilisé pour mettre en œuvre chacun des demi-tampons 102 à 108 de la figure 1. Le demi-tampon 200 comprend n blocs de circuit CB₀ à CB_{n-1'} un pour chaque bit à transmettre sur l'interface. Chaque bloc de circuits CB₀ à CBₙ₋₁ comprend par exemple une paire de portes C 202, 204.

Les portes C 202 des blocs de circuits CB₀ à CBₙ₋₁ ont chacune l'une de leurs entrées couplée à une ligne d'entrée de données correspondante 208 pour recevoir respectivement des signaux de données d'entrée I.0₀ à I.0ₙ₋₁, leur autre entrée couplée à une ligne d'accusé de réception 206 pour recevoir un signal d'accusé de réception O_ack provenant d'un demi-tampon suivant dans le pipeline, et leur sortie couplée à une ligne de sortie 212 correspondante fournissant respectivement des signaux de sortie correspondants O.0₀ à O.0ₙ₋₁.

Les portes C 204 des blocs de circuit CB₀ à CBₙ₋₁ ont chacune l'une de leurs entrées couplée à une ligne d'entrée de données 210 correspondante pour recevoir respectivement des signaux de données d'entrée correspondants I.1₀ à I.1ₙ₋₁, leur autre entrée couplée à la ligne d'accusé de réception 206 pour recevoir le signal d'accusé de réception O_ack provenant d'un demi-tampon suivant dans le pipeline, et leur sortie couplée à une ligne de sortie correspondante 214 fournissant des signaux de sortie correspondants O.1₀ à O.1ₙ₋₁.

Les lignes de sortie 212 et 214 se trouvant dans chaque bloc de circuits CB₀ à CBₙ₋₁ sont aussi couplées à des entrées correspondantes d'une porte NON OU 216, qui génère sur sa sortie sur une ligne 218 un signal d'accusé de réception pour le bloc de circuit. Les signaux d'accusé de réception sur les lignes 218 provenant de chacun des blocs de circuit CB₀ à CBₙ₋₁ sont fournis à des entrées correspondantes de la porte C 220, qui fournit sur sa ligne de sortie 222 un signal d'accusé de réception de sortie I_ack.

En fonctionnement, chaque porte C de la figure 2 a par exemple un fonctionnement défini par la table de vérité suivante, où A et B sont ses signaux d'entrée, et Z est son signal de sortie.

| A | B | Z |
|---|---|---|
| 0 | 0 | 0 |
| 0 | 1 | Z⁻¹ |
| 1 | 0 | Z⁻¹ |
| 1 | 1 | 1 |

Ainsi, lorsque les valeurs des signaux d'entrée A et B sont au même niveau logique, la sortie Z est mise à ce niveau logique. Lorsque les valeurs des signaux d'entrée A et B sont à des niveaux logiques différents entre eux, le circuit est dans un état de veille dans lequel la sortie Z reste inchangée.

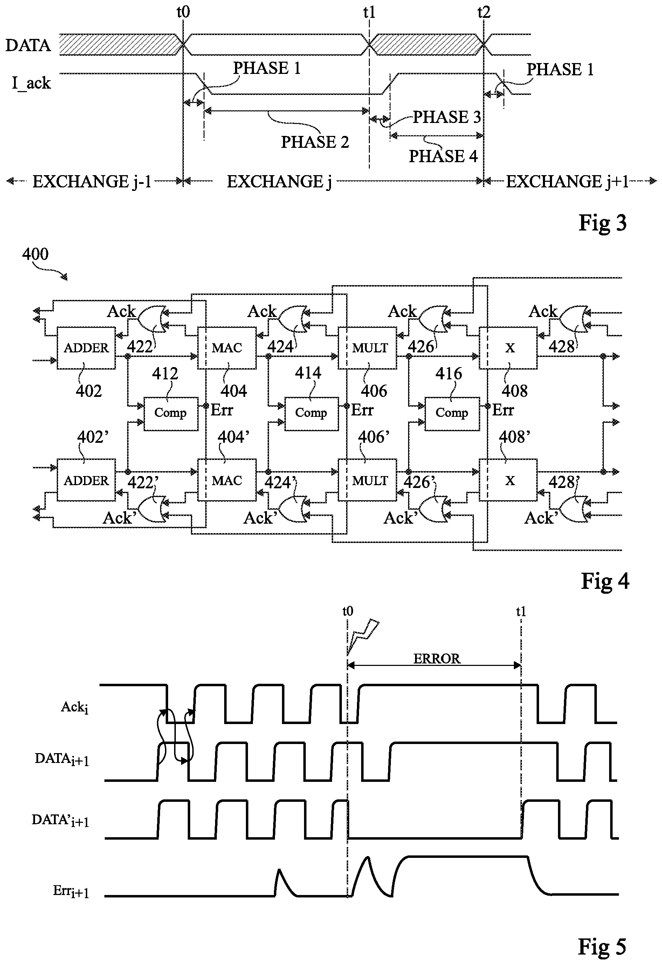

La figure 3 est un chronogramme illustrant un exemple de signaux d'un protocole de poignée de main mis en œuvre par le demi-tampon de la figure 2. Dans cet exemple, un protocole de poignée de main à quatre phases est mis en œuvre, mais dans des variantes de réalisation, on pourrait utiliser un protocole de poignée de main différent, comme un protocole de poignée de main à deux phases.

Un signal de données DATA en figure 3 représente par exemple les données fournies sur les lignes d'entrée I.0₀, I.1₀ à I.0ₙ₋₁, I.1ₙ₋₁ du demi-tampon. Le signal de données DATA est par exemple initialement bas à la fin d'un échange de rang (j-1) (EXCHANGE j-1), en d'autres termes les signaux sur toutes les lignes d'entrée sont par exemple à l'état bas. Le signal d'accusé de réception I_ack généré par le demi-tampon est par exemple initialement bas.

À un instant t0 au début d'un échange j (EXCHANGE j), le signal de données fait une transition, correspondant à une première phase (PHASE 1) du protocole de poignée de main. En supposant que le signal d'accusé de réception O_ack sur la ligne 206 est haut, peu de temps après le signal d'accusé de réception I_ack va passer à l'état bas correspondant à une deuxième phase (PHASE 2) du protocole de poignée de main.

À un instant t1, le signal de données DATA est amené de nouveau à l'état bas, ce qui correspond à une troisième phase (PHASE 3) du protocole de poignée de main. En supposant que le signal d'accusé de réception O_ack est passé à l'état bas, le signal d'accusé de réception I_ack va ainsi passer de nouveau à l'état haut, ce qui correspond à une quatrième phase (PHASE 4) du protocole de poignée de main.

De nouvelles données peuvent ensuite être transmises dans un échange (j+1) (EXCHANGE j+1), comme cela est représenté à un instant t2 en figure 3.

Bien que dans l'exemple de la figure 3 le signal d'accusé de réception I_ack soit initialement haut, puis passe à l'état bas lorsque des données sont reçues, dans des variantes de réalisation il pourrait être initialement bas, et passer à l'état haut lorsque des données sont reçues.

La figure 4 illustre schématiquement un pipeline asynchrone résistant aux rayonnements 400 selon un exemple de réalisation non revendiqué de la présente description. Ce pipeline est par exemple basé sur des principes similaires à ceux du pipeline décrit précédemment en référence aux figures 1 à 3.

Le pipeline 400 comprend une première série d'étages asynchrones, la figure 4 montrant quatre étages de la sorte mettant en œuvre respectivement un additionneur (ADDER) 402, un opérateur multiplieur accumulateur (MAC) 404, un multiplieur (MULT) 406, et un autre étage (X) 408, qui pourrait être n'importe quel type d'opérateur. Ce pipeline est dupliqué, la deuxième série d'étages étant référencée 402', 404', 406' et 408' en figure 4. Ainsi les étages 402', 404', 406' et 408' sont par exemple fonctionnellement équivalents aux étages respectifs 402, 404, 406 et 408, et vont ainsi générer des signaux de sortie sensiblement identiques en l'absence d'erreurs. Chaque étage 402 à 408 et 402' à 408' comprend par exemple un demi-tampon similaire à celui de la figure 2.

Des lignes de données de sortie de chaque étage 402, 402', 404, 404', 406, 406' et 408, 408' sont fournies à l'étage suivant dans chaque pipeline, et aussi à l'entrée d'un comparateur correspondant, trois de ces comparateurs 412, 414 et 416 étant illustrés en figure 4. Le comparateur 412 est couplé aux lignes de données de sortie des étages 402, 402', le comparateur 414 est couplé aux lignes de données de sortie des étages 404, 404' et le comparateur 416 est couplé aux lignes de données de sortie des étages 406, 406'. Chaque comparateur 412, 414, 416 génère par exemple un signal d'erreur Err, qui est activé, par exemple à un niveau haut, lorsqu'une discordance est détectée entre les signaux de données provenant d'étages de pipeline correspondants.

Un circuit de pause d'accusé de réception 422 propage le signal d'accusé de réception revenant vers chaque étage. Par exemple, un circuit de pause d'accusé de réception 422 fournit le signal d'accusé de réception Ack à l'étage 402, et de façon similaire des circuits de pause d'accusé de réception 422', 424, 424', 426, 426', 428 et 428' fournissent les signaux d'accusé de réception Ack ou Ack' aux étages 402', 404, 404', 406, 406', 408 et 408' respectivement. Chacun des circuits 422 à 428 et 422' à 428' comporte deux entrées. Par exemple, le circuit de pause d'accusé de réception fournissant le signal d'accusé de réception à un étage de rang i dans le pipeline a l'une de ses entrées couplée à la sortie d'accusé de réception de l'étage (i+1) dans le pipeline, et l'autre de ses entrées couplée à la sortie du comparateur associé à l'étage (i+1) du pipeline. De cette manière, sur la base du signal d'erreur Err résultant de la comparaison des signaux de données provenant de l'étage (i+1), le signal d'accusé de réception vers l'étage i peut être activé ou mis en pause.

Dans l'exemple de la figure 4, on a supposé que le signal d'accusé de réception passe à l'état bas pour informer l'étage précédent que les signaux de données peuvent être amenés à l'état bas, et ainsi les circuits de pause d'accusé de réception 422, 422' à 428, 428' sont mis en œuvre par des portes OU, qui vont maintenir les signaux d'accusé de réception hauts si le comparateur a une sortie haute indiquant la présence d'une discordance entre les sorties des étages. Bien sûr, dans des variantes de réalisation, on pourrait utiliser d'autres types de portes logiques, comme une porte ET, pour mettre en œuvre les circuits de pause d'accusé de réception, en fonction de la polarité du signal d'accusé de réception à générer et du signal d'erreur.

Le fonctionnement du circuit de la figure 4 va maintenant être décrit plus en détail en faisant référence à la figure 5.

La figure 5 est un chronogramme illustrant des exemples particuliers du signal d'accusé de réception Ackᵢ reçu par un étage i dans chacun des pipelines dupliqués, des signaux de données DATAᵢ₊₁, DATA'ᵢ₊₁ générés par les étages (i+1) des pipelines dupliqués, et du signal d'erreur Errᵢ₊₁ à la sortie du comparateur recevant les signaux de données DATAᵢ₊₁ et DATA'ᵢ₊₁.

Initialement, plusieurs cycles d'échanges sont illustrés dans lesquels le signal d'erreur Erri₊₁ reste bas, et ainsi des transitions dans les signaux de données déclenchent un front descendant du signal d'accusé de réception Ackᵢ, qui à son tour déclenche la réinitialisation des signaux de données, qui à son tour déclenche un front montant du signal d'accusé de réception Ackᵢ.

À un instant t0 en figure 5, on suppose qu'un SEU (ERROR) survient dans le pipeline dupliqué, amenant le signal DATA'ᵢ₊₁ dans ce pipeline a passer à l'état bas plus tôt que dans le cas normal. Cela crée une discordance entre les signaux de données DATAᵢ₊₁ et DATA'ᵢ₊₁, et ainsi le signal d'erreur Errᵢ₊₁ passe à l'état haut. Ainsi, le signal d'accusé de réception Ackᵢ passe à l'état haut peu de temps après et reste haut, provoquant une mise en pause de la transmission de données dans le pipeline.

Lorsque le signal DATAᵢ₊₁ passe de nouveau à l'état bas, le signal d'erreur commence à descendre, puis revient à l'état haut de nouveau sur un front montant suivant du signal de données DATAᵢ₊₁, et le signal de données conserve ensuite son état puisque le signal d'accusé de réception Ackᵢ n'a pas permis que de nouvelles données rentrent dans l'étage i. Ainsi, le signal d'accusé de réception Ackᵢ reste aussi à l'état haut.

À un instant t1, le changement d'état dans le signal de données DATA'ᵢ₊₁ provoqué par le SEU est par exemple revenu à sa valeur vraie, et ainsi le signal d'erreur Errᵢ₊₁ passe de nouveau à l'état bas. Cela libère le signal d'accusé de réception Ackᵢ, et la transmission dans le pipeline par exemple se poursuit. Ainsi, le SEU provoque seulement une pause dans la transmission de données, et non pas une réinitialisation des données maintenues dans le pipeline.

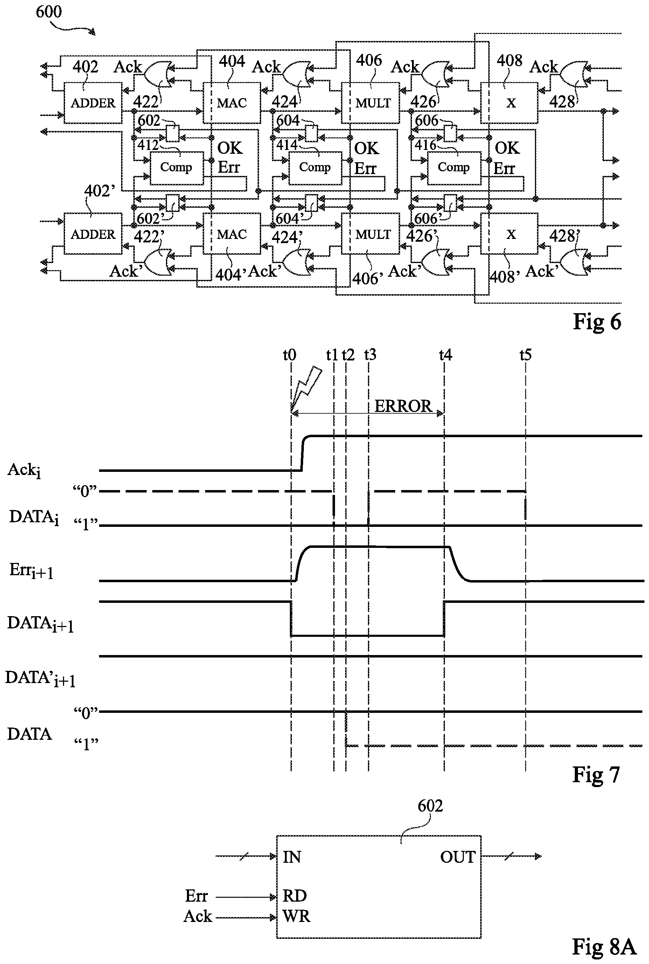

Bien que le mode de réalisation de la figure 4 assure une protection raisonnable contre les SEU dans de nombreuses applications, une difficulté pourrait survenir si une autre erreur survenait dans l'un des signaux de données des étages précédents avant que l'erreur courante ait été corrigée. Un autre mode de réalisation qui résout au moins partiellement ce problème va maintenant être décrit en faisant référence à la figure 6.

La figure 6 illustre schématiquement un pipeline selon un mode de réalisation couvert par l'invention asynchrone 600, qui est par exemple similaire au pipeline 400 de la figure 4, et les éléments similaires portent les mêmes références et ne seront pas décrits de nouveau en détail. Par rapport au mode de réalisation de la figure 4, le pipeline 600 de la figure 6 comprend en plus des circuits de mémorisation non volatile 602, 604 et 606 associés respectivement aux étages 402, 404 et 406, et des circuits de mémorisation non volatile 602', 604' et 606', associés respectivement aux étages 402', 404' et 406' .

Le circuit de mémorisation non volatile associé à un étage de rang i dans le pipeline a par exemple une entrée et une sortie couplées aux lignes de sortie de données de l'étage i, et une entrée couplée à la sortie du comparateur de l'étage i. En outre, il comporte par exemple une entrée couplée à la sortie du comparateur de l'étage (i+1). Par exemple, le circuit de mémorisation non volatile 602 a une entrée et une sortie couplées aux lignes de sortie de l'étage 402, une entrée couplée à la sortie du comparateur 412, et une entrée couplée à la sortie du comparateur 414. De façon similaire, le circuit de mémorisation non volatile 602' a une entrée et une sortie couplées aux lignes de sortie de l'étage 402', une entrée couplée à la sortie du comparateur 412, et une entrée couplée à la sortie du comparateur 414.

Chaque circuit de mémorisation non volatile est par exemple agencé pour mémoriser les signaux de données se trouvant à la sortie de l'étage de pipeline i correspondant si le comparateur de l'étage i n'indique pas d'erreur, en d'autres termes si les signaux de données concordent dans les pipelines dupliqués. De plus, si une erreur est détectée par le comparateur de l'étage (i+1), le circuit de mémorisation non volatile est par exemple adapté à fournir sa valeur mémorisée, qui va écraser la valeur fournie par l'étage i, de sorte que le circuit est immunisé contre un autre SEU survenant dans l'étage i. En plus, les circuits de mémorisation non volatile permettent par exemple aux pipelines d'être réinitialisés à partir d'un état mémorisé à la suite d'une réinitialisation ou d'une coupure d'alimentation du pipeline.

Alors que dans l'exemple de la figure 6 il y a des circuits de mémorisation non volatile associés à chaque étage dans les deux pipelines dupliqués, dans certains modes de réalisation, l'un de ces ensembles de circuits de mémorisation non volatile pourrait être omis. Par exemple, les circuits 602', 604' et 606' pourraient être omis, et les sorties des circuits 602, 604 et 606 pourraient additionnellement être couplées aux sorties des étages 402', 404' et 406' respectivement.

Le fonctionnement du circuit de la figure 6 va maintenant être décrit plus en détail en faisant référence au chronogramme de la figure 7.

La figure 7 illustre un signal d'accusé de réception Ackᵢ d'un étage de rang i, le signal de données DATAᵢ à la sortie de l'étage i, le signal d'erreur Errᵢ₊₁ provenant du comparateur de l'étage (i+1), les signaux de données DATAᵢ₊₁ et DATA'ᵢ₊₁ à la sortie de l'étage (i+1), et le signal de données DATA à la sortie des circuits de mémorisation non volatile.

Dans cet exemple, on a supposé que le signal d'accusé de réception Ackᵢ est initialement bas, le bit "0" du signal de données DATAᵢ, représenté par une ligne en pointillés, est initialement haut, le bit "1" du signal de données DATAᵢ, représenté par une ligne en trait plein, est initialement bas, les signaux de données DATAᵢ₊₁ et DATA'ᵢ₊₁ sont initialement hauts, le bit "0" du signal de données DATA, représenté par une ligne en pointillés, est initialement haut, le bit "1" du signal de données DATA, représenté par une ligne en trait plein, est initialement haut et le signal d'erreur Errᵢ₊₁ est initialement bas. Les états des bits "0" et "1" du signal de données DATAᵢ ont par exemple été mémorisés dans le circuit de mémorisation non volatile correspondant.

À un instant t0 on suppose qu'un SEU (ERROR) survient dans le pipeline, provoquant la descente au niveau bas du signal de données DATAᵢ₊₁ plus tôt que la normale. Cela crée une discordance entre les signaux de données DATAᵢ₊₁ et DATA'ᵢ₊₁, et ainsi le signal d'erreur Errᵢ₊₁ passe à l'état haut. Ainsi, le signal d'accusé de réception Ackᵢ passe à l'état haut peu de temps après et reste haut, provoquant la mise en pause de la transmission de données dans le pipeline. À l'instant t1 le bit "0" du signal de données DATAᵢ est forcé à l'état bas puisque le signal d'accusé de réception a mis le circuit en pause.

À un instant t2 peu de temps après que le signal d'erreur Errᵢ₊₁ a été activé, le dispositif de mémorisation non volatile est commandé pour lire les valeurs précédentes du signal de données DATAᵢ sur les lignes de sortie de l'étage i. À un instant t3, le signal DATAᵢ prend les valeurs précédemment mémorisées dans les circuits de mémorisation non volatile (DATA). Une fois que le signal DATAᵢ₊₁ a récupéré du SEU à un instant t4, le traitement continue sur la base de la valeur chargée du signal de données DATAᵢ, sans risque de fautes.

À un instant t5, après que le signal d'erreur Errᵢ₊₁ soit passé à l'état bas de nouveau, le bit "0" du signal DATAᵢ passe par exemple de nouveau à l'état bas, prêt pour l'échange de données suivant.

La figure 8A illustre schématiquement plus en détail un bloc de circuit mettant en œuvre le circuit de mémorisation non volatile 602 selon un exemple de réalisation. Les autres circuits de mémorisation non volatile du pipeline sont par exemple mis en œuvre par un bloc de circuit similaire.

Le circuit 602 reçoit par exemple des bits de données d'entrée IN à partir des lignes de sortie de l'étage i correspondant, fournit des bits de données de sortie OUT sur les lignes de sortie de l'étage i correspondant, et reçoit des commandes de lecture et d'écriture RD, WR. La commande de lecture RD correspond par exemple au signal d'erreur Err provenant du comparateur de l'étage (i+1). Le signal d'écriture est par exemple généré par la sortie du signal d'accusé de réception provenant du circuit 422.

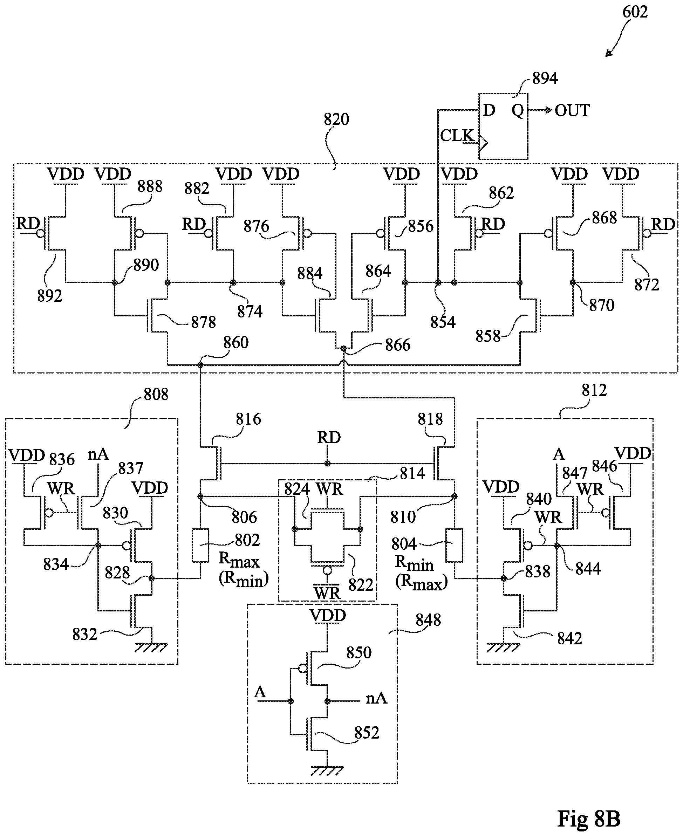

La figure 8B illustre schématiquement plus en détail une mise en œuvre d'une partie du circuit de mémoire non volatile 602 de la figure 8A selon un exemple de réalisation. Cette mise en œuvre correspond à la mémorisation d'un bit de données, et en pratique ce circuit est par exemple dupliqué pour chacun des signaux de données à mémoriser.

Le circuit 602 comprend par exemple une paire d'éléments non volatils 802, 804, qui sont par exemple des éléments résistifs programmables. Chacun de ces éléments peut par exemple être programmé pour prendre l'un d'une pluralité d'états résistifs. Les éléments résistifs 802 et 804 peuvent être d'un type quelconque d'élément à commutation de résistance pour lequel la résistance est programmable par le sens d'un courant qu'on fait passer dedans.

Par exemple, les éléments à commutation de résistance 802, 804 sont des éléments à couple de transfert de spin ayant une anisotropie dans le plan ou perpendiculaire au plan, comme cela est décrit plus en détail dans la publication intitulée "Magnonic spin-transfer torque MRAM with low power, high speed, and error-free switching", N. Mojumder et al., IEDM Tech. Digest (2010), et dans la publication intitulée "Electric toggling of magnets", E. Tsymbal, Natural Materials Vol 11, janvier 2012. Un avantage des dispositifs MRAM est qu'ils sont intrinsèquement robustes vis-à-vis des rayonnements.

En variante, les éléments à commutation de résistance 802, 804 pourraient être ceux utilisés dans des mémoires à commutation résistive RAM RedOx (RAM à réduction-oxydation), qui sont par exemple décrits plus en détail dans la publication intitulée "Redox-Based Resistive Switching Memories - Nanoionic Mechanisms, Prospects and Challenges", Rainer Waser et al., Advanced Materials 2009, 21, pages 2632 à 2663. Dans encore un autre exemple, les éléments résistifs pourraient être ceux utilisés dans des FeRAM (RAM ferroélectriques) ou dans des PCRAM (RAM à changement de phase) ou tout dispositif mémoire à résistance variable.

Quel que soit le type des éléments à commutation résistive 802, 804, un bit de données est par exemple mémorisé de manière non volatile en mettant l'un des éléments à une résistance relativement haute (Rₘₐₓ), et l'autre à une résistance relativement basse (Rₘᵢₙ). Dans l'exemple de la figure 8b, l'élément 802 est programmé pour avoir une résistance Rₘₐₓ et l'élément 804 une résistance Rₘᵢₙ représentant une valeur du bit de données, et comme cela est représenté par les références Rₘᵢₙ et Rₘₐₓ entre parenthèses, la programmation opposée des valeurs de résistance mémorise la valeur opposée du bit de données.

Chacun des éléments à commutation de résistance 802, 804 a par exemple seulement deux états résistifs correspondant aux résistances haute et basse Rₘₐₓ et Rₘᵢₙ, mais les valeurs exactes de Rₘᵢₙ et Rₘₐₓ peuvent varier en fonction de conditions comme le processus de fabrication, les matériaux, les variations de température, etc.

Le bit de donnée non volatile représenté par les éléments résistifs 802, 804 dépend duquel des éléments résistifs à la résistance Rₘₐₓ ou Rₘᵢₙ, en d'autres termes des résistances relatives. Les éléments résistifs 802, 804 sont par exemple choisis de telle sorte que Rₘₐₓ soit toujours notablement plus grande que Rₘᵢₙ, par exemple supérieure d'au moins 20 %. En général, le rapport entre la résistance Rₘₐₓ et la résistance Rₘᵢₙ est par exemple compris entre 1,2 et 10000. Rₘᵢₙ est par exemple dans la région des 2 kilo-ohms ou moins, et Rₘₐₓ est par exemple dans la région des 6 kilo-ohms ou plus, bien que de nombreuses autres valeurs soient possibles.

Il apparaîtra clairement à l'homme de l'art que dans certains modes de réalisation, plutôt que les deux éléments résistifs 802, 804 soient programmables, un seul soit programmable. Dans un tel cas, l'autre élément résistif a par exemple une résistance fixe à un niveau intermédiaire situé environ à mi-chemin entre Rₘᵢₙ et Rₘₐₓ, par exemple égal, avec une tolérance de 10 %, à (Rₘᵢₙ+(Rₘₐₓ-Rₘᵢₙ)/2). Par exemple, l'un des éléments résistifs 802, 804 pourrait correspondre à une résistance de valeur fixe. En variante, l'un des éléments résistifs 802, 804 pourrait être constitué d'une paire d'éléments résistifs programmables couplés en parallèle entre eux et dans des orientations opposées, de sorte que quel que soit le sens dans lequel chaque élément est programmé, la valeur de résistance reste relativement constante au niveau intermédiaire.

L'élément 802 est par exemple couplé entre un nœud 806 et un premier circuit d'écriture 808. Élément 804 est par exemple couplé entre le nœud 810 et un deuxième circuit d'écriture 812. Les nœuds 806 et 810 sont par exemple couplés entre eux par l'intermédiaire d'un commutateur 814 contrôlé par le signal d'écriture WR. En outre, les nœuds 806 et 810 sont par exemple couplés par l'intermédiaire de transistors respectifs 816 et 818 à un circuit de lecture 820. Les transistors 816 et 818 sont par exemple contrôlés par le signal de lecture RD.

Le commutateur 814 comprend par exemple un transistor PMOS 822 et un transistor NMOS 824, chacun étant couplé par ses nœuds de conduction principaux entre les nœuds 806 est 810. Le transistor 822 est par exemple contrôlé par l'inverse *W̅R̅* du signal d'écriture WR, et le transistor 824 est par exemple contrôlé par le signal d'écriture WR. Les transistors 822 et 824 sont rendus conducteurs pendant une phase d'écriture, de sorte que le courant passe dans les éléments 802 et 804 dans une direction allant du circuit 808 vers le circuit 812, ou dans la direction opposée, en fonction du bit de donnée à mémoriser.

Le premier circuit d'écriture 808 comprend par exemple un nœud 828 couplé à l'élément 802, et aussi à un rail de tension d'alimentation VDD par l'intermédiaire d'un transistor PMOS 830, et à la masse par l'intermédiaire d'un transistor NMOS 832. Les grilles des transistors 830 et 832 sont couplées à un nœud 834, qui est lui-même couplé par l'intermédiaire d'un transistor PMOS 836 au rail de tension d'alimentation VDD. En outre, le nœud 834 est couplé à une ligne d'entrée recevant l'inverse nA d'un signal de données d'entrée A par l'intermédiaire d'un transistor 837. Les transistors 836 et 837 sont contrôlés sur leurs nœuds de grille par le signal d'écriture WR.

De façon similaire, le deuxième circuit d'écriture 812 comprend par exemple un nœud 838 couplé à l'élément 804, et aussi au rail de tension d'alimentation VDD par l'intermédiaire d'un transistor PMOS 840, et à la masse par l'intermédiaire d'un transistor NMOS 842. Les grilles des transistors 840 et 842 sont couplées à un nœud 844, qui est lui-même couplé par l'intermédiaire d'un transistor PMOS 846 au rail de tension d'alimentation VDD. En outre, le nœud 844 est couplé à une ligne d'entrée recevant le signal de données d'entrée A par l'intermédiaire d'un transistor 847. Les transistors 846 et 847 sont contrôlés au niveau de leurs nœuds de grille par le signal d'écriture WR.

Comme cela est représenté par le circuit 848, le signal nA est par exemple généré en appliquant le signal A à l'entrée d'un inverseur constitué par exemple d'un transistor PMOS 850 et d'un transistor NMOS 852.

En fonctionnement, le signal A correspond à un bit du signal d'entrée de données IN du circuit, et lorsque le signal d'écriture WR est activé, un courant d'écriture est appliqué dans les éléments 802 et 804 dans une direction basée sur le signal A.

Le circuit de lecture 820 dans l'exemple de la figure 8B est par exemple capable de générer un bit de sortie en détectant les résistances programmées relatives des éléments résistifs 802, 804 lorsque le signal de lecture RD est activé. En outre, le circuit est par exemple résistant aux rayonnements pour réduire le risque qu'un SEU provoquant une erreur soit propagé par le circuit.

Le circuit de lecture 820 comprend par exemple un nœud 854 qui fournit le bit de sortie lu dans les éléments résistifs 802, 804. Le nœud 854 est couplé au rail de tension d'alimentation VDD par l'intermédiaire d'un transistor 856 et à un nœud 860 par l'intermédiaire d'un transistor NMOS 858. Le nœud 860 est couplé à un nœud de conduction principal du transistor NMOS 816. Le nœud 854 est aussi couplé par l'intermédiaire d'un transistor PMOS 862 au rail de tension d'alimentation VDD, le transistor 862 étant contrôlé par le signal de lecture RD. Un transistor 864 a sa grille couplée au nœud 854, et ses nœuds de conduction principaux couplés respectivement à la grille du transistor 856 et à un autre nœud 866 lui-même couplé au transistor 818. Un transistor PMOS 868 a par exemple sa grille couplée au nœud 854, et ses nœuds de conductions principaux couplés respectivement au rail de tension d'alimentation VDD et à un autre nœud 870. Le nœud 870 est en outre couplé par l'intermédiaire d'un transistor 872 au rail de tension d'alimentation VDD, le transistor 872 étant par exemple un transistor PMOS contrôlé au niveau de sa grille par le signal de lecture RD.

Le circuit de lecture 820 comprend aussi par exemple un nœud 874 couplé au rail de tension d'alimentation VDD par l'intermédiaire d'un transistor 876 et au nœud 860 par l'intermédiaire d'un transistor NMOS 878. Le nœud 874 est aussi couplé par l'intermédiaire d'un transistor PMOS 882 au rail de tension d'alimentation VDD, le transistor 882 étant contrôlé par le signal de lecture RD. Un transistor 884 a sa grille couplée au nœud 874, et ses nœuds de conduction principaux couplés respectivement à la grille du transistor 876 et au nœud 866. Un transistor PMOS 888 a par exemple sa grille couplée au nœud 874, et ses nœuds de conduction principaux couplés respectivement au rail de tension d'alimentation VDD et à un autre nœud 890. Le nœud 890 est en outre couplé par l'intermédiaire d'un transistor 892 au rail de tension d'alimentation VDD, le transistor 892 étant par exemple un transistor PMOS contrôlé au niveau de sa grille par le signal de lecture RD.

Le nœud 854 est par exemple couplé par l'intermédiaire d'une bascule 894, synchronisée par un signal d'horloge CLK, à une sortie OUT du circuit de mémorisation non volatile.

En fonctionnement, lorsque le signal de lecture RD est activé, les transistors 816 et 818 sont rendus conducteurs. En outre, les transistors 862, 872, 882 et 892 sont rendus non conducteurs. Les transistors 856, 864, 876 et 884 vont ainsi conduire des courants formant un premier courant de lecture dans le transistor 818, et les transistors 878, 888, 858 et 868 vont ainsi conduire des courants formant un deuxième courant de lecture dans le transistor 816. Ces courants vont amener les tensions sur les nœuds 854 et 874 à basculer sur la base des résistances programmées des éléments 802 et 804.

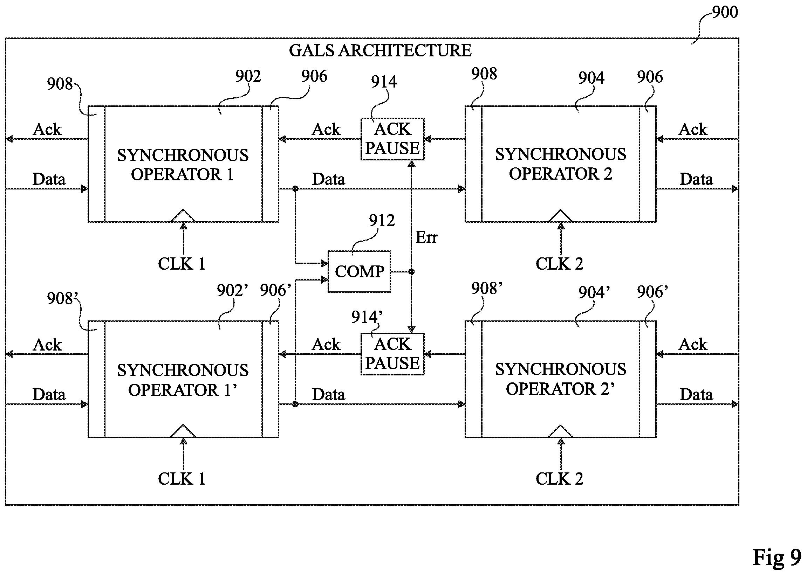

Alors que les modes de réalisation des figures 6 et 8 décrits précédemment concernent un pipeline asynchrone, dans des variantes de réalisation les mêmes principes pourraient être appliqués à d'autres types de circuits assurant des communications asynchrones, comme on va le décrire maintenant en faisant référence à la figure 9.

La figure 9 illustre schématiquement une architecture GALS (globalement asynchrone, localement synchrone) (GALS ARCHITECTURE) 900 comprenant une paire de circuits 902, 904, qui sont par exemple tous les deux synchrones et capables de communiquer entre eux de manière asynchrone, et une autre paire de circuits 902', 904', qui sont par exemple fonctionnellement équivalents aux circuits 902, 904 respectivement. Par exemple, les circuits 902, 902' correspondent respectivement à un opérateur synchrone 1 (SYNCHRONOUS OPERATOR 1) et à son double (SYNCHRONOUS OPERATOR 1') contrôlés par un signal d'horloge CLK1, et les circuits 904, 904' correspondent respectivement à un opérateur synchrone 2 (SYNCHRONOUS OPERATOR 2) et à son double (SYNCHRONOUS OPERATOR 2') contrôlé par un signal d'horloge CLK2.

Dans l'exemple de la figure 9, les circuits 902 et 902' communiquent avec les circuits 904, 904' dans les deux directions. Les interfaces asynchrones entre les circuits 902, 904 et entre les circuits 902', 904' comprennent chacune par exemple une ou plusieurs lignes de données (DATA) et une ligne d'accusé de réception ACK. Les circuits 902, 902' comprennent chacun par exemple respectivement un encapsuleur asynchrone 906, 906' formant une interface entre les portions synchrones des circuits et l'interface asynchrone. De façon similaire, les circuits 904, 904' comprennent chacun par exemple respectivement un encapsuleur asynchrone 908, 908' formant une interface entre les portions synchrones des circuits et l'interface asynchrone. Dans certains modes de réalisation, l'un ou l'autre des circuits 902, 902' ou les deux communiquent aussi avec d'autres circuits (non illustrés en figure 9), par l'intermédiaire d'autres lignes de données et d'accusé de réception, par exemple couplées à des encapsuleurs asynchrones 908, 908' des circuits 902, 902'. En plus ou à la place, l'un ou l'autre des circuits 904, 904' communique aussi avec d'autres circuits (non illustrés en figure 9) par l'intermédiaire d'autres lignes de données et d'accusé de réception, par exemple couplées à des encapsuleurs asynchrones 906, 906' des circuits 904, 904' .

Lesdites une ou plusieurs lignes de données formant l'interface entre les circuits 902 et 904 sont par exemple couplées à un comparateur (COMP) 912, qui compare les signaux sur les lignes de données correspondantes, et active un signal d'erreur Err sur sa sortie quand il y a une discordance entre l'un quelconque des signaux. Ce signal d'erreur Err est passé à des circuits de pause d'accusé de réception 914 et 914' (ACK PAUSE) couplés respectivement dans les chemins des signaux d'accusé de réception générés par les circuits 904 et 904'. Ainsi, une discordance détectée entre les signaux de données va provoquer la mise en pause des signaux d'accusé de réception jusqu'à ce que la donnée récupère sa valeur correcte.

Un avantage des modes de réalisation décrits ici est qu'une détection et une correction d'erreur peuvent être réalisées pour des communications asynchrones sans augmenter de plus qu'un facteur deux la surface et la consommation d'énergie du circuit.

Avec la description ainsi faite d'au moins un mode de réalisation illustratif, diverses altérations, modifications et améliorations apparaîtront facilement à l'homme de l'art. Par exemple, alors que dans les modes de réalisation des figures 4 et 6 la détection d'une discordance entre les signaux de données des étages de rang (i+1) est utilisée pour mettre en pause les signaux d'accusé de réception vers les étages de rang i, dans des variantes de réalisation elle pourrait être utilisée pour mettre en pause des signaux d'accusé de réception vers les étages de rang (i+1) ou vers des étages précédents se trouvant avant les étages de rang i.

En outre, bien qu'on ait décrit une mise en œuvre en référence à la figure 8B dans laquelle un circuit de mémorisation non volatile est mis en œuvre en utilisant des éléments à commutation de résistance programmables par le sens d'un courant qu'on fait passer dedans, dans des variantes de réalisation on pourrait utiliser d'autres technologies de mémorisation de données non volatiles, avec des conceptions de circuits appropriées pour programmer et lire un ou plusieurs éléments de mémorisation. En outre, d'autres mises en œuvre du circuit de la figure 8B seraient possibles, par exemple sur la base d'un ou plusieurs des circuits décrits dans la publication de R. Rajaei et al. intitulée "Soft Error-Tolerant Design of MRAM-based Non-Volatile Latches for Sequential Logics", IEEE TRANSACTIONS ON MAGNETICS, novembre 2014, dont le contenu est inclus ici comme référence dans les limites autorisées par la loi.

En outre, il sera clair pour l'homme de l'art que la tension d'alimentation VDD dans les divers modes de réalisation pourrait avoir un niveau quelconque, par exemple entre 1 et 3 V, et plutôt que d'être à 0 V, la tension de masse pourrait aussi être considérée comme une tension d'alimentation qui pourrait avoir un niveau quelconque, comme un niveau négatif.

En outre, il sera clair pour l'homme de l'art que, dans n'importe lequel des modes de réalisation décrits ici, tous les transistors NMOS pourraient être remplacés par des transistors PMOS et/ou tous les transistors PMOS pourraient être remplacés par des transistors NMOS. L'homme de l'art saura facilement comment mettre en œuvre l'un quelconque des circuits en utilisant seulement des transistors PMOS ou seulement des transistors NMOS, par exemple en inversant les rails de tension d'alimentation. En outre, bien qu'on ait décrit ici des transistors basés sur la technologie MOS, dans des variantes de réalisation on pourrait utiliser d'autres technologies de transistors, comme la technologie bipolaire.

En outre, il sera clair pour l'homme de l'art que les divers circuits décrits ici pourraient être mis en œuvre dans du silicium massif, ou dans une structure de silicium sur isolant (SOI). Par exemple, les circuits pourraient être mis en œuvre en utilisant la technologie FD-SOI (SOI complètement déplétée). Un avantage des structures SOI est que, en raison de leur isolation locale du substrat, elles procurent une bonne résistance aux erreurs résultant de rayonnements. En outre, dans de telles structures, on peut utiliser une polarisation du corps pour accélérer l'écriture des éléments non volatils.

En outre, il apparaîtra clairement à l'homme de l'art que les divers éléments décrits en relation avec les divers modes de réalisation pourraient être combinés, dans des variantes de réalisation, selon diverses combinaisons. Par exemple, les circuits de mémorisation non volatile du circuit de la figure 9 pourraient être mis en œuvre par le circuit de mémorisation non volatile des figures 8A et 8B.

## Revendications

1. Circuit asynchrone comprenant :
un premier circuit (404, 904) adapté à recevoir, à partir d'un premier autre circuit (402 902), un premier signal d'entrée de données sur une première ligne d'entrée de données et à générer un premier signal d'accusé de réception et un premier signal de sortie de données ;
un deuxième circuit (404', 904') adapté à recevoir, à partir d'un deuxième autre circuit (402', 902'), un deuxième signal d'entrée de données sur une deuxième ligne d'entrée de données et à générer un deuxième signal d'accusé de réception et un deuxième signal de sortie de données, le deuxième circuit étant fonctionnellement équivalent au premier circuit ;
un comparateur (414, 912) adapté à détecter une discordance entre les premier et deuxième signaux de sortie de données ;
un autre comparateur (412) adapté à détecter une discordance entre les premier et deuxième signaux d'entrée de données ;
au moins un circuit de mise en pause d'accusé de réception (422, 422', 914, 914') adapté à empêcher la propagation des premier et deuxième signaux d'accusé de réception vers les premier et deuxième autres circuits si une discordance est détectée par le comparateur ou par l'autre comparateur ; et
un circuit de mémoire non volatile (602) couplé à la première ligne d'entrée de données et adapté à mémoriser une première valeur du premier signal d'entrée de données lorsque l'autre comparateur n'indique pas de discordance entre les premier et deuxième signaux d'entrée de données.

2. Circuit asynchrone selon la revendication 1, dans lequel le circuit de mémoire non volatile (602) est en outre adapté à fournir la première valeur mémorisée en réponse à une discordance détectée entre les premier et deuxième signaux de sortie de données.

3. Circuit asynchrone selon la revendication 2, dans lequel le circuit de mémoire non volatile (602) est adapté à fournir la première valeur mémorisée sur des lignes de données transmettant les premier et deuxième signaux d'entrée de données.

4. Circuit asynchrone selon l'une quelconque des revendications 1 à 3, dans lequel le circuit de mémoire non volatile comprend au moins un élément de mémorisation non volatile (802, 804) programmable pour maintenir, de manière non volatile, l'un d'une pluralité d'états résistifs.

5. Circuit asynchrone selon l'une quelconque des revendications 1 à 4, dans lequel ledit au moins un circuit de mise en pause d'accusé de réception (422, 422', 914, 914') est adapté à propager les premier et deuxième signaux d'accusé de réception soit une fois que le comparateur (414, 912) indique une concordance entre les premier et deuxième signaux d'entrée de données, soit une fois que le comparateur indique une concordance entre les premier et deuxième signaux de sortie de données.

6. Circuit asynchrone selon l'une quelconque des revendications 1 à 5, dans lequel chacun desdits au moins un circuit de mise en pause d'accusé de réception (422, 422', 914, 914') est une porte logique adaptée à recevoir le premier ou le deuxième signal d'accusé de réception et un signal de sortie (Err) du comparateur.

7. Circuit asynchrone selon l'une quelconque des revendications 1 à 6, dans lequel les premier et deuxième circuits (904, 904') sont des circuits de réception synchrones, chacun des premier et deuxième circuits comprenant un encapsuleur asynchrone (908, 908') et :
le premier autre circuit est un premier circuit de transmission synchrone (902) comprenant un encapsuleur asynchrone (906) et adapté à générer le premier signal d'entrée de données (D1) et à le transmettre au premier circuit ; et
le deuxième autre circuit est un deuxième circuit de transmission synchrone (902') comprenant un encapsuleur asynchrone (906') et adapté à générer le deuxième signal d'entrée de données (D2) et à le transmettre au deuxième circuit.

8. Pipeline asynchrone comprenant le circuit asynchrone de l'une quelconque des revendications 1 à 7, dans lequel le pipeline asynchrone comprend :
un premier sous-pipeline comprenant une première pluralité d'étages (402 à 408) dont l'un comprend le premier circuit ; et
un deuxième sous-pipeline comprenant une deuxième pluralité d'étages (402' à 408') dont l'un comprend le deuxième circuit.

9. Procédé de détection et de correction de dérangements par événement singulier dans un circuit asynchrone comprenant :
recevoir par un premier circuit (404, 904), à partir d'un premier autre circuit (402, 902) un premier signal d'entrée de données sur une première ligne d'entrée de données et générer par le premier circuit un premier signal d'accusé de réception et un premier signal de sortie de données ;
recevoir par un deuxième circuit (404', 904'), à partir d'un deuxième autre circuit (402', 902'), un deuxième signal d'entrée de données sur une deuxième ligne d'entrée de données et générer par le deuxième circuit un deuxième signal d'accusé de réception et un deuxième signal de sortie de données, le deuxième circuit étant fonctionnellement équivalent au premier circuit ;
comparer, par un comparateur (414, 912), les premier et deuxième signaux de sortie de données pour détecter une discordance ;
comparer, par un autre comparateur (412), les premier et deuxième signaux d'entrée de données pour détecter une discordance ;
empêcher, par au moins un circuit de mise en pause d'accusé de réception (422, 422', 914, 914'), la propagation des premier et deuxième signaux d'accusé de réception vers les premier et deuxième autres circuits si une discordance est détectée entre les premier et deuxième signaux d'entrée de données ou entre les premier et deuxième signaux de sortie de données ; et
mémoriser, par un circuit de mémoire non volatile (602) couplé à la première ligne d'entrée de données, une première valeur du premier signal d'entrée de données lorsque l'autre comparateur n'indique pas de discordance entre les premier et deuxième signaux d'entrée de données.

## Patentansprüche

1. Eine asynchrone Schaltung, die Folgendes aufweist:
eine erste Schaltung (404, 904), die geeignet ist, von einer ersten weiteren Schaltung (402, 902) ein erstes Dateneingangssignal auf einer ersten Dateneingangsleitung zu empfangen und ein erstes Empfangsbestätigungssignal und ein erstes Datenausgangssignal zu erzeugen;
eine zweite Schaltung (404', 904'), die geeignet ist, von einer zweiten weiteren Schaltung (402', 902') ein zweites Dateneingangssignal auf einer zweiten Dateneingangsleitung zu empfangen und ein zweites Empfangsbestätigungssignal und ein zweites Datenausgangssignal zu erzeugen, wobei die zweite Schaltung funktional äquivalent zur ersten Schaltung ist;
einen Komparator (414, 912), der geeignet ist, eine Abweichung zwischen dem ersten und dem zweiten Datenausgangssignal zu erkennen;
einen weiteren Komparator (412), der dazu ausgelegt ist, eine Abweichung zwischen dem ersten und dem zweiten Dateneingangssignal zu erkennen;
mindestens eine Empfangsbestätigungspausenschaltung (422, 422', 914, 914'), die so ausgelegt ist, dass sie die Weiterleitung des ersten und des zweiten Empfangsbestätigungssignals an die erste und die zweite weitere Schaltung verhindert, wenn durch den Komparator oder den weiteren Komparator eine Abweichung erkannt wird; und
eine nichtflüchtige Speicherschaltung (602), die mit der ersten Dateneingangsleitung verbunden ist und einen ersten Wert des ersten Dateneingangssignals speichern kann, wenn der weitere Komparator keine Abweichung zwischen dem ersten und dem zweiten Dateneingangssignal anzeigt.

2. Asynchrone Schaltung nach Anspruch 1, wobei die nichtflüchtige Speicherschaltung (602) ferner dazu ausgelegt ist, den gespeicherten ersten Wert als Reaktion auf eine erkannte Abweichung zwischen dem ersten und dem zweiten Ausgangsdatensignal auszugeben.

3. Asynchrone Schaltung nach Anspruch 2, wobei die nichtflüchtige Speicherschaltung (602) dazu ausgelegt ist, den gespeicherten ersten Wert auf Datenleitungen auszugeben, die die ersten und zweiten Dateneingangssignale übertragen.

4. Asynchrone Schaltung nach einem der Ansprüche 1 bis 3, wobei die nichtflüchtige Speicherschaltung mindestens ein nichtflüchtiges Speicherelement (802, 804) aufweist, das so programmiert werden kann, dass es auf nichtflüchtige Weise einen von mehreren Widerstandszuständen beibehält.

5. Asynchrone Schaltung nach einem der Ansprüche 1 bis 4, wobei die mindestens eine Empfangsbestätigungspausenschaltung (422, 422', 914, 914') so ausgelegt ist, dass sie das erste und das zweite Empfangsbestätigungssignal weiterleitet, wenn der Komparator (414, 912) eine Übereinstimmung zwischen dem ersten und dem zweiten Dateneingangssignal anzeigt oder wenn der Komparator eine Übereinstimmung zwischen dem ersten und dem zweiten Datenausgangssignal anzeigt.

6. Asynchrone Schaltung nach einem der Ansprüche 1 bis 5, wobei jede der mindestens einen Empfangsbestätigungspausenschaltung (422, 422', 914, 914') ein Logikgatter ist, das das erste oder zweite Empfangsbestätigungssignal und ein Ausgangssignal (Err) des Komparators empfangen kann.

7. Asynchrone Schaltung nach einem der Ansprüche 1 bis 6, wobei die erste und die zweite Schaltung (904, 904') synchrone Empfangsschaltungen sind, wobei die erste und die zweite Schaltung jeweils einen asynchronen Wrapper (908, 908') aufweisen und:
die erste weitere Schaltung eine erste synchrone Sendeschaltung (902) ist, die einen asynchronen Wrapper (906) aufweist und dazu geeignet ist, das erste Dateneingangssignal (D1) zu erzeugen und an die erste Schaltung zu übertragen; und
die zweite weitere Schaltung eine zweite synchrone Sendeschaltung (902') ist, die einen asynchronen Wrapper (906') aufweist und dazu geeignet ist, das zweite Dateneingangssignal (D2) zu erzeugen und an die zweite Schaltung zu übertragen.

8. Asynchrone Pipeline mit der asynchronen Schaltung nach einem der Ansprüche 1 bis 7, wobei die asynchrone Pipeline Folgendes aufweist:
eine erste Teil-Pipeline, die eine erste Mehrzahl von Stufen (402 bis 408) aufweist, von denen eine die erste Schaltung umfasst; und
eine zweite Teil-Pipeline, die eine zweite Vielzahl von Stufen (402' bis 408') aufweist, von denen eine die zweite Schaltung umfasst.

9. Verfahren zum Erkennen und Korrigieren von Einzelereignis-Störungen in einer asynchronen Schaltung, wobei das Verfahren Folgendes aufweist:
Empfangen eines ersten Dateneingangssignals auf einer ersten Dateneingangsleitung durch eine erste Schaltung (404, 904) von einer ersten weiteren Schaltung (402, 902) und Erzeugen eines ersten Empfangsbestätigungssignals und eines ersten Datenausgangssignals durch die erste Schaltung;
Empfangen eines zweiten Dateneingangssignals von einer zweiten weiteren Schaltung (402', 902') auf einer zweiten Dateneingangsleitung durch eine zweite Schaltung (404', 904') und Erzeugen eines zweiten Empfangsbestätigungssignals und eines zweiten Datenausgangssignals durch die zweite Schaltung, wobei die zweite Schaltung funktional äquivalent zur ersten Schaltung ist;
Vergleichen des ersten und zweiten Datenausgangssignals durch einen Komparator (414, 912), um eine Abweichung zu erkennen;
Vergleichen des ersten und des zweiten Eingangsdatensignals durch einen weiteren Komparator (412), um eine Abweichung zu erkennen;
Verhindern der Weiterleitung der ersten und zweiten Empfangsbestätigungssignale an die erste und zweite weitere Schaltung durch mindestens eine Empfangsbestätigungspausenschaltung (422, 422', 914, 914'), wenn eine Abweichung zwischen den ersten und zweiten Dateneingangssignalen oder den ersten und zweiten Datenausgangssignalen erkannt wird; und
Speichern eines ersten Wertes des ersten Dateneingangssignals durch eine nichtflüchtige Speicherschaltung (602), die mit der ersten Dateneingangsleitung gekoppelt ist, wenn der weitere Komparator keine Abweichung zwischen dem ersten und dem zweiten Dateneingangssignal anzeigt.

## Claims

1. An asynchronous circuit comprising:
a first circuit (404, 904) adapted to receive, from a first further circuit (402, 902), a first data input signal on a first data input line and to generate a first acknowledgement signal and a first data output signal;
a second circuit (404', 904') adapted to receive, from a second further circuit (402', 902'), a second data input signal on a second data input line and to generate a second acknowledgement signal and a second data output signal, the second circuit being functionally equivalent to the first circuit;
a comparator (414, 912) adapted to detect a mismatch between the first and second data output signals;
a further comparator (412) adapted to detect a mismatch between the first and second data input signals;
at least one acknowledgement pause circuit (422, 422', 914, 914') adapted to prevent the propagation of the first and second acknowledgement signals to the first and second further circuits if a mismatch is detected by the comparator or by the further comparator; and
a non-volatile memory circuit (602) coupled to the first data input line and adapted to store a first value of the first data input signal when the further comparator does not indicate a mismatch between the first and second data input signals.

2. The asynchronous circuit of claim 1, wherein the non-volatile memory circuit (602) is further adapted to output the stored first value in response to a detected mismatch between the first and second output data signals.

3. The asynchronous circuit of claim 2, wherein the non-volatile memory circuit (602) is adapted to output the stored first value on data lines transmitting the first and second data input signals.

4. The asynchronous circuit of any of claims 1 to 3, wherein the non-volatile memory circuit comprises at least one non-volatile storage element (802, 804) programmable to maintain, in a non-volatile fashion, one of a plurality of resistive states.

5. The asynchronous circuit of any of claims 1 to 4, wherein the at least one acknowledgement pause circuit (422, 422', 914, 914') is adapted to propagate the first and second acknowledgement signals either once the comparator (414, 912) indicates a match between the first and second data input signals or once the comparator indicates a match between the first and second data output signals.

6. The asynchronous circuit of any of claims 1 to 5, wherein each at least one acknowledgement pause circuit (422, 422', 914, 914') is a logic gate adapted to receive the first or second acknowledgement signal and an output signal (Err) of the comparator.

7. The asynchronous circuit of any of claims 1 to 6, wherein the first and second circuits (904, 904') are synchronous reception circuits, each of the first and second circuits comprising an asynchronous wrapper (908, 908') and:
the first further circuit is a first synchronous transmission circuit (902) comprising an asynchronous wrapper (906) and adapted to generate the first data input signal (D1) and to transmit it to the first circuit; and
the second further circuit is a second synchronous transmission circuit (902') comprising an asynchronous wrapper (906') and adapted to generate the second data input signal (D2) and to transmit it to the second circuit.

8. An asynchronous pipeline comprising the asynchronous circuit of any of claims 1 to 7, wherein the asynchronous pipeline comprises:
a first sub-pipeline comprising a first plurality of stages (402 to 408) of which one comprises said first circuit; and
a second sub-pipeline comprising a second plurality of stages (402' to 408') of which one comprises said second circuit.

9. A method of detecting and correcting single event upsets in an asynchronous circuit comprising:
receiving by a first circuit (404, 904) from a first further circuit (402, 902) a first data input signal on a first data input line and generating by the first circuit a first acknowledgement signal and a first data output signal;
receiving by a second circuit (404', 904') from a second further circuit (402', 902') a second data input signal on a second data input line and generating by the second circuit a second acknowledgement signal and a second data output signal, the second circuit being functionally equivalent to the first circuit;
comparing, by a comparator (414, 912), the first and second data output signals to detect a mismatch;
comparing, by a further comparator (412), the first and second input data signals to detect a mismatch;
preventing, by at least one acknowledgement pause circuit (422, 422', 914, 914'), the propagation of the first and second acknowledgement signals to the first and second further circuits if a mismatch is detected between the first and second data input signals or the first and second data output signals; and
storing, by a non-volatile memory circuit (602) coupled to the first data input line, a first value of the first data input signal when the further comparator does not indicate a mismatch between the first and second data input signals.
